# EUROPÄISCHE PATENTSCHRIFT

(11) **EP 1 377 880 B1**
(45) Veröffentlichungstag und Bekanntmachung des Hinweises auf die Patenterteilung: **01.06.2005**
(21) Anmeldenummer: 02727499.2
(22) Anmeldetag: 28.03.2002
(51) Int. Cl.: G03F 7/20, G03H 1/08

(54) **LITHOGRAPH UND MIKROSKOP MIT EINDIMENSIONALER TRIGGERMASKE UND VERFAHREN ZUM HERSTELLEN DIGITALER HOLOGRAMME IN EINEM SPEICHERMEDIUM**
LITHOGRAPH AND MICROSCOPE WITH ONE-DIMENSIONAL TRIGGER MASK AND METHOD FOR PRODUCTION OF DIGITAL HOLOGRAMS IN A STORAGE MEDIUM
LITHOGRAPHE ET MICROSCOPE POURVUS D'UN MASQUE DE DECLENCHEMENT UNIDIMENSIONNEL ET PROCEDE DE PRODUCTION D'HOLOGRAMMES NUMERIQUES DANS UN MOYEN MEMOIRE

(30) Priorität: 12.04.2001 DE 10118593; 02.08.2001 DE 10137859
(43) Veröffentlichungstag der Anmeldung: 07.01.2004
(73) Patentinhaber: tesa scribos GmbH, 69126 Heidelberg (DE)
(72) Erfinder: NOEHTE, Steffen, 69469 Weinheim (DE); DIETRICH, Christoph, 69126 Heidelberg (DE); THOMANN, Robert, 69121 Heidelberg (DE); GERSPACH, Matthias, 69221 Dossenheim (DE); STADLER, Stefan, 22359 Hamburg (DE); LEIBER, Jörn, 22529 Hamburg (DE)
(74) Vertreter: Rox, Thomas Dr.
(86) Internationale Anmeldenummer: PCT/EP2002/003516
(87) Internationale Veröffentlichungsnummer: WO 2002/084404

(56) Entgegenhaltungen:
- EP-A- 0 947 884
- EP-A- 0 950 924
- EP-A- 0 965 888
- US-A- 3 925 785
- US-A- 4 688 932

## Beschreibung

Die vorliegende Erfindung betrifft einen Lithographen zum Herstellen digitaler Hologramme in einem Speichermedium. Darüber hinaus betrifft die Erfindung ein Verfahren zum Herstellen digitaler Hologramme in einem Speichermedium.

Digitale Hologramme sind zweidimensionale Hologramme, die aus einzelnen Punkten mit unterschiedlichen optischen Eigenschaften bestehen und aus denen bei Beleuchtung mit einer kohärenten elektromagnetischen Welle, insbesondere Lichtwelle durch Beugung in Transmission oder Reflexion Bilder und/oder Daten reproduziert werden. Die unterschiedlichen optischen Eigenschaften der einzelnen Punkte können Reflexionseigenschaften beispielsweise durch Oberflächentopographie, variierende optische Weglängen im Material des Speichermediums (Brechungsindizes) oder Farbwerte des Materials sein.

Die optischen Eigenschaften der einzelnen Punkte werden von einem Computer berechnet, es handelt sich somit um sogenannte computergenerierte Hologramme (CGH). Mit Hilfe des fokussierten Schreibstrahls werden während des Schreibens des Hologramms die einzelnen Punkte des Hologramms in das Material eingeschrieben, wobei der Fokus im Bereich der Oberfläche oder im Material des Speichermediums liegt. Eine Fokussierung bewirkt im Bereich des Fokus eine geringe Einwirkungsfläche auf das Material des Speichermediums, so daß eine Vielzahl von Punkten des Hologramms in einem kleinen Bereich geschrieben werden kann. Die optische Eigenschaft des jeweils geschriebenen Punktes hängt dabei von der Intensität des Schreibstrahls ab. Dazu wird der Schreibstrahl in zwei Dimensionen mit variierender Intensität über die Oberfläche des Speichermediums gescannt. Die Modulation der Intensität des Schreibstrahls erfolgt dabei entweder über eine interne Modulation der Lichtquelle, beispielsweise eine Laserdiode, oder über eine externe Modulation eines Schreibstrahls außerhalb der Lichtquelle, beispielsweise mit Hilfe von optoelektronischen Elementen. Darüber hinaus kann die Lichtquelle als gepulster Laser ausgebildet sein, dessen Pulslängen steuerbar sind, so dass über die Pulslängen eine Steuerung der Intensität des Schreibstrahls erfolgen kann.

Durch das Abscannnen des intensitätsmodulierten Schreibstrahls entsteht somit eine Fläche mit einer unregelmäßigen Punkteverteilung, das digitale Hologramm. Dieses kann zum Kennzeichnen und Individualisieren beliebiger Gegenstände eingesetzt werden.

Scannende lithographische Systeme sind an sich weit verbreitet. Beispielsweise werden scannende optische Systeme in herkömmliche Laserdrucker eingebaut. Diese Systeme können jedoch zur Herstellung von Hologrammen nicht eingesetzt werden, da sich die Anforderungen für diesen Anwendungszweck gegenüber denen bei Laserdruckern deutlich unterscheiden. Die Auflösung liegt bei guten Drucksystemen bei etwa 2500 dpi, während bei der Herstellung von Hologrammen eine Auflösung von etwa 25.000 dpi erforderlich ist. Außerdem werden bei der digitalen Holographie nur vergleichsweise kleine Flächen beschrieben. Diese sind beispielsweise 1 bis 5 mm² groß, wobei auch andere Größen möglich sind. Die Genauigkeit des Schreibrasters muß bei einem Lithographen zur Herstellung digitaler Hologramme von beispielsweise 1000 x 1000 Punkten auf einer Fläche von 1 x 1 mm² etwa ± 0,1 mm in beide orthogonale Richtungen betragen. Darüber hinaus sollte die Schreibgeschwindigkeit etwa 1 Mpixel/s betragen, damit jeweils ein Hologramm in einer Zeit von ca. ls geschrieben werden kann.

Digitale Hologramme können mittels konventioneller Scanmethoden hergestellt werden, bei denen mit stehender Optik der Winkel des einfallenden Strahles variiert wird. Auf diesem Prinzip arbeiten beispielsweise Scanspiegellithographen mit Galvo- und/oder Polygonscannern.

Bei allen bisher bekannten Scanmethoden besteht ein Nachteil darin, dass bei einem Lithographen mit einem einfachen Aufbau keine zeitliche Steuerung des Schreibstrahls möglich ist, die bei den zu erreichenden Schreibgeschwindigkeiten ein vorgegebenes Punktraster des digitalen Hologramms einzuhalten in der Lage ist.

Der vorliegenden Erfindung liegt daher das technische Problem zugrunde, mittels optischer Lithographie computergenerierte Hologramme möglichst schnell und mit geringem Aufwand bei gleichzeitiger genauer Steuerung der zeitlichen Triggerung und der Positionierung des Schreibstrahls zu schreiben.

Das zuvor aufgezeigte technische Problem wird durch ein Verfahren zum Herstellen digitaler Hologramme in einem Speichermedium gelöst, bei dem ein Schreibstrahl auf das Speichermedium fokussiert und eindimensional relativ zum Speichermedium bewegt wird, bei dem ein Abtaststrahl auf eine eine Mehrzahl von Triggerlinien aufweisende Triggermaske fokussiert und eindimensional quer zu den Triggerlinien bewegt wird, wobei die Bewegung des Abtaststrahls mit der Bewegung des Schreibstrahls gekoppelt wird, bei dem während des Abtastens der Triggerlinien in Abhängigkeit von der Anordnung der Triggerlinien ein zeitliches Triggersignal erzeugt wird, bei dem mit Hilfe des zeitlichen Triggersignals die Intensität des Schreibstrahls auf dem Speichermedium geregelt wird, und bei dem das Hologramm zeilenweise durch punktweises Einbringen von Strahlungsenergie geschrieben wird, wobei das Speichermedium quer zur Scanrichtung der Zeilen um einen vorgegebenen Abstand für ein Schreiben benachbarter Linien des Hologramms verstellt wird.

Eindimensionale Bewegung im Sinne der vorliegenden Erfindung bedeutet eine Bewegung, die sich im wesentlichen in einer Richtung erstreckt. Eine eindimensionale Bewegung ist daher insbesondere eine geradlinige Bewegung, jedoch kann eine eindimensionale Bewegung im Sinne der Erfindung auch krummlinig sein, also von einer geraden Linie abweichend.

Erfindungsgemäß ist also erkannt worden, dass mit Hilfe eines mit dem Schreibstrahl in seiner Bewegung gekoppelten Abtaststrahls ein zeitliches Triggersignal mit einer eindimensionalen Triggermaske ähnlich einem Barcode erzeugt werden kann. Dabei sind bevorzugt die Triggerlinien parallel, also in einem orthogonalen Raster angeordnet, dieses ist jedoch nicht zwingend erforderlich. Mit Hilfe der zeitlichen Triggerinformation und einer zusätzlichen Intensitätsinformation, die grundsätzlich unabhängig von der Triggermaske erzeugt werden kann, kann das digitale Hologramm punktweise in Zeilen nacheinander geschrieben werden. Daher sind die Bewegungen der Schreibstrahls und des Speichermediums aufeinander abgestimmt. Ist eine aktuelle Zeile geschrieben, so wird beispielsweise das Speichermedium um einen vorgegebenen Abstand verschoben, so dass anschließend die weitere Zeile geschrieben werden kann. Ebenso ist es möglich, das Speichermedium kontinuierlich zu verschieben und die Zeilen des Hologramms während des Verstellens des Speichermediums quer zur Scanrichtung in das Material des Speichermediums einzuschreiben.

Wie zuvor ausgeführt, wird während des Abtastens der Triggerlinien in Abhängigkeit von der Anordnung der Triggerlinien ein zeitliches Triggersignal erzeugt. Insbesondere kann das zeitliche Triggersignal dann erzeugt werden, wenn der Abtaststrahl mit einer der abzutastenden Triggerlinien übereinstimmt.

Übereinstimmung bedeutet in diesem Fall, dass entweder das Erreichen oder Verlassen der Triggerlinie oder ein beliebiger Zwischenbereich zwischen den Triggerlinien als Schwellwert eines von der Triggermaske reflektierten oder transmittierten Strahles gemessen wird, oder dass die Triggermaske aktive Elemente aufweist, die bei einer vorgegebenen Beleuchtungsstärke das zeitliche Triggersignal erzeugen können. Dieser Wert wird innerhalb der Messgenauigkeit so eingestellt, dass die Regelung in der erforderlichen Geschwindigkeit erfolgen kann.

In bevorzugter Weise wird der Abtaststrahl in einem vorgegebenen Bewegungsverhältnis zum Schreibstrahl bewegt. Somit kann der Abtaststrahl eine Triggermaske abscannen, deren Fläche größer als der zu beschreibende Bereich des Speichermediums ist. Ist die Triggermaske beispielsweise 10-fach größer als das zu erzeugende Hologramm, so ist die Bewegung des Abtaststrahls im Verhältnis 10:1 proportional zur Bewegung des Schreibstrahls vergrößert. Soll also beispielsweise ein Hologramm mit einer Fläche von 1x1 mm² beschrieben werden, so scannt der Abtaststrahl eine Triggermaske mit einer Fläche von 10x10 mm² ab. Die vorgenannten Größen sind beispielhaft und stellen keine Beschränkung der Erfindung dar.

Weiter ist es bevorzugt, dass der Abtaststrahl auf eine Größe fokussiert wird, die maximal der Triggerlinienabmessung der Triggermaske entspricht. Somit wird sichergestellt, dass hinreichend genau das Übereinstimmen mit der Triggerlinie abgetastet wird und ein ausreichend genaues zeitliches Triggersignal erzeugt werden kann.

Die optischen Eigenschaften der Triggerlinien können in unterschiedlicher Weise ausgebildet sein, wobei jeweils Techniken eingesetzt werden, die an sich aus dem Stand der Technik, insbesondere von optischen Speichermedien wie Compact Disc (CD) oder Digital Versatile Disc (DVD) bekannt sind.

Bei einer ersten Ausführungsform weisen die Triggerlinien der Triggermaske eine von der umgebenden Oberfläche seitlich neben den Triggerlinien unterschiedliche Reflektivität auf, so dass der von der Oberfläche der Triggermaske reflektierte Strahl mit einem Detektor detektiert werden kann. Aus der Intensität des auf der Detektorfläche fokussierten reflektierten Abtaststrahls wird dann das Triggersignal abgeleitet.

Bei einer zweiten Ausführungsform weisen die Triggerlinien der Triggermaske eine von der umgebenden Oberfläche seitlich neben den Triggerlinien unterschiedliche Transmissionseigenschaften auf, so dass der durch die Triggermaske transmittierte Strahl mit einem Detektor detektiert werden kann. Aus der Intensität des transmittierten derart gemessenen Strahls wird dann das Triggersignal abgeleitet.

Es können auch Abschnitte mit reflektierenden und mit transmittierenden Eigenschaften miteinander in einer Triggerlinie kombiniert werden.

Bei einer dritten Ausführungsform weisen die Triggerlinien der Triggermaske eine Oberflächenstruktur, beispielsweise in Form von Rillen auf, so dass der an der Oberfläche der Triggermaske reflektierend gebeugte Strahl detektiert werden kann. Aus der Intensität des reflektierten Strahls, der sich im wesentlichen aus der Überlagerung der nullten und beiden ersten Beugungsordnungen ergibt, wird dann das Triggersignal abgeleitet.

Sämtliche zuvor beispielhaft angeführten Ausführungsformen der Erfindung beruhen darauf, dass durch die optischen Eigenschaften der Triggermaske der Abtaststrahl derart beeinflusst wird, dass sich daraus das Übereinstimmen mit einer Triggerlinie nachweisen und in ein Steuersignal für die Intensitätssteuerung des Schreibstrahls umwandeln lässt.

Eine weitere Ausgestaltung der Triggermaske besteht darin, dass diese aktive Pixel aufweist und somit direkt das zeitliche Triggersignal erzeugen kann. Durch unterschiedliche Ansteuerungen der Pixel können somit auch unterschiedlich Triggerspuren ohne ein Auswechseln der Triggermaske an sich erzeugt werden.

In bevorzugter Weise wird als aktive Triggermaske ein räumlicher Strahlmodulator (spatial light modulator - SLM) verwendet, mit dem eine zeitlich variabel einstellbare Triggermaske realisieren lässt.

Das oben aufgezeigte technische Problem wird gemäß einer zweiten Lehre der vorliegenden Erfindung durch einen Lithographen mit den Merkmalen des Anspruches 15 gelöst.

Die zuvor beschriebene Funktionsweise der vorliegenden Erfindung sowie deren bevorzugte Ausgestaltungen können auch in vorteilhafter Weise bei einem scannenden, insbesondere konfokalen Mikroskop eingesetzt werden. Bei einem derartigen Mikroskop wird die zu untersuchende Oberfläche mit einem Lichtstrahl abgetastet bzw. beobachtet und die reflektierte Lichtintensität wird gemessen. Während des Abtastens der Oberfläche wird dann das Bild aus den gemessenen Intensitäten des reflektierten Lichts zusammengesetzt. Die Oberfläche wird also in einem Raster abgetastet, wie es zuvor beschrieben worden ist.

Vorliegend wird dazu im Strahlengang des reflektierten Strahls vor oder bevorzugt hinter dem Objektiv ein Strahlteiler angeordnet, um die reflektierte Strahlung auf einen optischen Sensor zu leiten. Dieser misst die reflektierte Intensität.

Mit einem derartigen Mikroskop wird das technische Problem gelöst, eine Oberfläche möglichst schnell und mit geringem Aufwand zu beobachten bzw. abzutasten. Dieses steht im Einklang mit der dem zuvor beschriebenen Lithographen zugrundeliegenden technische Problem. Die zuvor für den Lithographen beschriebenen Vorteile werden ebenfalls bei einem derartigen Mikroskop erreicht.

Nachfolgend wird die Erfindung anhand von Ausführungsbeispielen mit Bezug auf die beigefügte Zeichnung näher erläutert wird. In der Zeichnung zeigen
- Fig. 1: ein Ausführungsbeispiel eines erfindungsgemäßen Lithographen,
- Fig. 2: ein Ausführungsbeispiel einer Triggermaske und
- Fig. 3: ein erfindungsgemäßes Mikroskop mit einem Aufbau, der im wesentlichen dem Aufbau des in Fig. 1 dargestellten Lithographen entspricht.

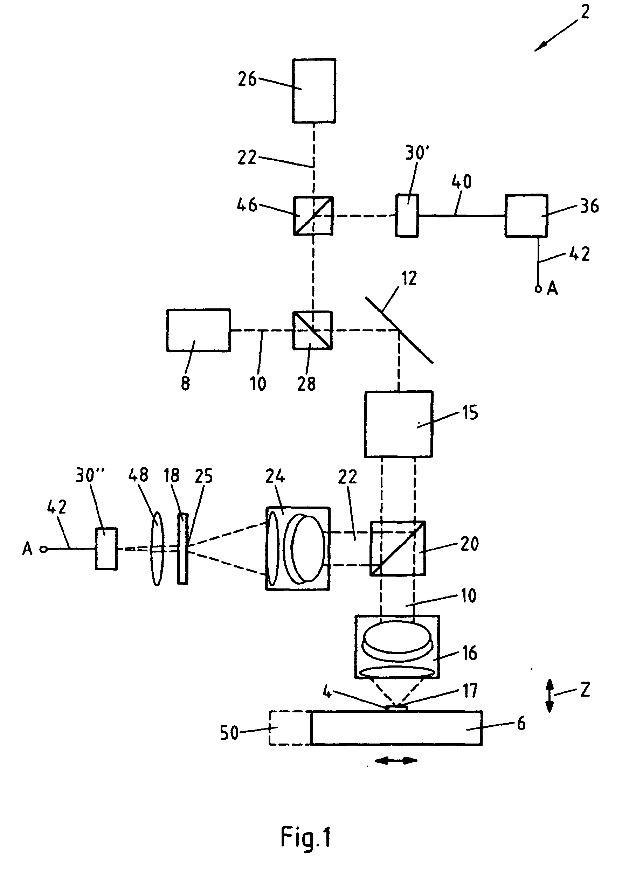

Fig. 1 zeigt ein Ausführungsbeispiel eines erfindungsgemäßen Lithographen 2 zum Herstellen digitaler Hologramme in einem Speichermedium 4, das auf einem Träger 6 angeordnet ist. Eine Lichtquelle 8 zum Erzeugen eines Schreibstrahls 10 weist bevorzugt einen Laser oder eine Laserdiode auf, so daß der Schreibstrahl 10 als Laserstrahl ausgebildet ist.

Der Lithograph 2 weist weiterhin Antriebsmittel zum eindimensionalen Bewegen des Schreibstrahls 10 relativ zum Speichermedium 4 auf, die als galvanisch angetriebene Scanspiegel 12 ausgebildet sind und beispielsweise den Schreibstrahl 10 in zur Zeichenebene der Fig. 1 senkrechten Richtung ablenken. Der Spiegel 12 stellt also eine x-Scanspiegelanordnung dar. Anstelle des galvanischen Scanspiegels 12 kann auch ein drehbarer Polygonspiegel eingesetzt werden.

Optional ist weiterhin ein Strahlaufweiter bzw. Kollimator 15 im Strahlengang hinter dem Scanspiegel 12 angeordnet, um einen aufgeweiteten Schreibstrahl 10 zu erzeugen.

Ein erstes Objektiv 16 fokussiert den Schreibstrahl 10 auf das zu beschreibende Speichermedium 4, so daß im Fokus 17 in Abhängigkeit von der gebündelten Intensität des Schreibstrahls 10 die optische Eigenschaft des Speichermediums 4 verändert wird oder unverändert bleibt.

Erfindungsgemäß ist eine zweidimensionale Triggermaske 18 vorgesehen, auf die ein durch einen Strahlteiler 20 aus dem Schreibstrahl 10 ausgekoppelter Abtaststrahl 22 mit einem zweiten Objektiv 24 in einem Fokus 25 fokussiert wird.

Der Abtaststrahl 22 wird durch eine zweite Lichtquelle 26 erzeugt, der mit einem Strahlteiler 28 in den Strahlengang des Schreibstrahls 10 vor dem Scanspiegel 12 eingekoppelt wird. Der Abtaststrahl 22 weist eine vom Schreibstrahl 10 abweichende Wellenlänge oder Polarisation auf, so daß der Strahlteiler 28 als dichroitischer oder polarisierender Strahlteiler ausgebildet ist. Der Strahlteiler 20 ist dann entsprechend dichroitisch oder polarisierend ausgebildet, um den Abtaststrahl 22 aus dem gemeinsamen Strahlengang auszukoppeln.

Der Abtaststrahl 22 ist also unabhängig von der Intensitätsmodulation des Schreibstrahls 10, so dass dieser auch ausgeschaltet, also mit einer Intensität gleich Null eingestellt werden kann.

Dagegen ist es auch möglich, den Abtaststrahl 22 als Teilstrahl aus dem Schreibstrahl auszukoppeln, ohne dass der Abtaststrahl 22 von einer separaten Lichtquelle erzeugt werden muß. Die Strahlteiler 20 und 28 sind dann als teildurchlässige Strahlteiler ausgebildet.

Beide Objektive 16 und 24 weisen jeweils drei Linsen eines fokussierenden Linsensystems auf. Jedoch kommt es auf die genaue Ausgestaltung der Objektive 16 und 24 nicht an. Die Objektive 16 und 24 können dabei vorzugsweise so ausgebildet sein, dass deren Winkelablenkungen in x-Richtung linear voneinander abhängen, wodurch eine lineare Kopplung zwischen den Bewegungen der Foki 17 und 25 entsteht.

Wie sich aus dem Aufbau des Lithographen 2 gemäß Fig. 1 ergibt, bewegen die Antriebsmittel, also der Scanspiegel 12 nicht nur den Schreibstrahl 10 sondern auch den Abtaststrahl 22. Denn der Strahlteiler 20 ist im Strahlengang des Schreibstrahls 10 hinter dem Scanspiegel 12 angeordnet. Somit bewegt sich der Abtaststrahl 22 in gleicher Weise eindimensional wie der Schreibstrahl 10, so daß der Abtaststrahl 22 relativ zur Oberfläche der Triggermaske 18 bewegt wird. Daraus ergibt sich, dass die Bewegung des Abtaststrahls 22 mit der Bewegung des Schreibstrahls 10 gekoppelt ist.

Weiterhin ist ein Detektor 30' oder ein Detektor 30'' alternativ oder kumulativ zum Aufnehmen des durch die optischen Eigenschaften der jeweiligen Triggerlinien der Triggermaske 18 in der Intensität variierten Abtaststrahls 22 vorgesehen. Die. zwei verschiedenen Positionen sind in Fig. 1 dargestellt. Die Funktionsweise der Detecktoren 30' und 30'' ist ähnlich und wird weiter unten näher erläutert.

Weiterhin sind Steuermittel 36 zum Erzeugen eines Triggersignals vorgesehen, mit den Detektoren 30' und/oder 30'' verbunden. Dazu sind Leitungen 40 und 42 (in Fig. 1 bei den Punkten A unterbrochen dargestellt) vorgesehen. Entsprechend den Signalen der Detektoren wird dann das zeitliche Triggersignal erzeugt.

Weiterhin erzeugen die Steuermittel 36 ein Intensitätssteuersignal, das über eine nicht dargestellte Leitung zum Steuern der Intensität des Schreibstrahls 10 auf die Lichtquelle 8 übertragen wird. Die Steuermittel 36 sind als Computer ausgebildet. Durch das übermittelte Intensitätssteuersignal wird der Schreibstrahl 10 in Abhängigkeit von der Position des Fokus 25 des Abtaststrahls 22 auf der Triggermaske 18, die mit der Position des Fokus 17 des Schreibstrahls 10 auf dem Speichermedium 4 gekoppelt ist, moduliert.

Mit anderen Worten wird der Schreibstrahl 10 für ein Schreiben von Hologrammpunkten mit zwei oder mehr verschiedenen Intensitätswerten eingestellt. Bei einem binären Schreiben wird die Intensität zwischen zwei verschiedenen Werten hin- und hergeschaltet, je nach dem, ob ein Punkt geschrieben werden soll oder nicht. Ebenso ist ein Schreiben von Hologrammpunkten mit einer Grauwertabstufung möglich und sinnvoll.

Wenn jedoch, wie oben beschrieben wurde, der Abtaststrahl 22 als Teilstrahl des Schreibstrahls 10 ausgekoppelt wird, ohne dass es einer separaten Lichtquelle bedarf, dann ist es für die Erfassung des Fokus 25 auf der Triggermaske 18 allerdings erforderlich, dass der niedrigere oder niedrigste Intensitätswert des Schreibstrahls 10 nicht gleich Null ist. Dadurch wird gewährleistet, dass der Abtaststrahl 22 immer eine Mindestintensität für ein Erzeugen eines Triggersignals aufweist.

Weiterhin wird bei dem in Fig. 1 dargestellten Aufbau des Lithographen 2 ein längenbezogenes Übersetzungsverhältnis zwischen der Bewegung des Schreibstrahls 10 auf dem Speichermedium 4 des Abtaststrahls 22 auf der Triggermaske 18 vorgegeben. Dieses wird durch unterschiedliche Brennweiten der beiden Objektive 16 und 26 realisiert. Ist beispielsweise die Brennweite des ersten Objektives 16 um einen Faktor 10 kleiner als die Brennweite des zweiten Objektivs 24, so ist die Bewegung des Fokus 25 des Abtaststrahls 22 auf der Triggermaske 18 um den gleichen Faktor 10 mal größer als die Bewegung des Fokus 17 auf der Oberfläche des Speichermediums 4. In der Fig. 1 ist aus Platzgründen lediglich ein Brennweitenverhältnis von ca. 2 dargestellt. Dieses verdeutlich aber, dass es nicht auf ein bestimmtes Verhältnis bei der vorliegenden Ausgestaltung der Erfindung ankommt.

Weiterhin ist der Träger 6 mit einem schematisch dargestellten Antrieb 50 verbunden, der schrittweise das Speichermedium zwischen jeweils zwei zu beschreibenden Zeilen des Hologramms verstellt. Die Richtung des Verstellens ist in Fig. 1 mit einem Doppelpfeil dargestellt und verläuft in der Zeichenebene der Fig. 1 horizontal. Dadurch ist ein Schreiben der Zeilen des Hologramms in einem orthogonalen Muster möglich. Daneben kann der Antrieb den Träger 6 auch kontinuierlich verstellen, so dass die Zeilen in einem nicht orthogonalen Muster geschrieben werden, wenn das Speichermedium 4 während des Scannens mit Hilfe des Scanspiegels 12 bewegt wird.

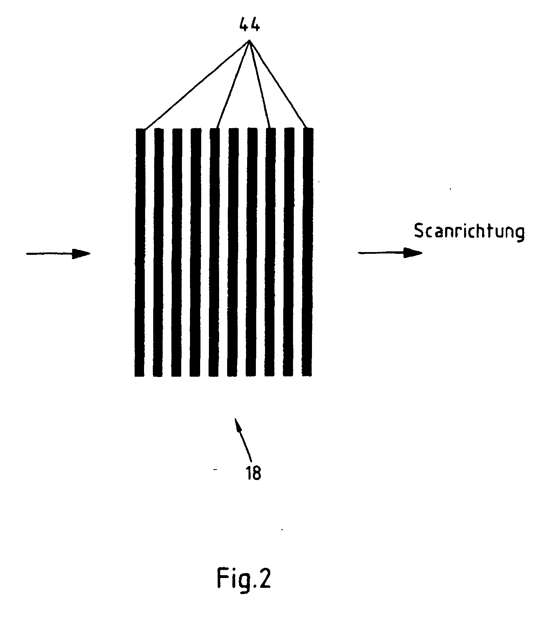

Wie Fig. 2 zeigt, weist die Triggermaske 18 eine Mehrzahl von Triggerlinien 44 auf. Diese sind in einem orthogonalen Raster angeordnet und weisen im wesentlichen gleiche Abstände zueinander auf. Ganz allgemein können die Triggerlinien 44 aber in einer vorgegebenen Anordnung vorliegen, bei der die Triggerlinien selbst eine beliebig verlaufende, also auch gekrümmte Form und variierende Abstände zueinander aufweisen. Denn die Anordnung der Triggerlinien 44 gibt das zu schreibende Punktraster des digitalen Hologramms wieder.

Der Abtaststrahl scannt die Triggerlinien quer, vorzugsweise senkrecht zu deren Verlauf ab, ähnlich wie es beim Erfassen eines Barcodes der Fall ist. Wegen der länglichen Erstreckung der Triggerlinien 44 kommt es daher nicht auf eine genaue Justierung des Abtaststrahls 22 auf der Triggermaske 18 an. Vorzugsweise können am Anfang und/oder am Ende der Triggerlinien 44 in Scanrichtung spezielle Codes ausgebildet sein, die es ermöglichen, aus dem vom Triggermaske beeinflussten Strahl ein Anfangs- und/oder ein Endsignal erzeugt werden kann. Die Codes können dabei beispielsweise in unterschiedlich breiten Triggerlinien enthalten sein, ähnlich wie es bei einem Barcode der Fall ist.

Die Triggermaske 18 kann eine Oberfläche mit unterschiedlichen Reflexionseigenschaften aufweisen. Dazu ist die Triggermaske 18 zu einem Teil mit einer reflektierenden Schicht versehen. Ebenso können die unterschiedlichen Reflexionseigenschaften als verschiedenen Färbungen des Materials-der Triggermaske ausgebildet sein. Ebenso können unterschiedliche refraktive Eigenschaften des Materials die verschiedenen Reflexionseigenschaften bewirken. Schließlich kann die Triggermaske als räumlicher Strahlmodulator (spatial light modulator - SLM) ausgebildet sein. Dadurch wird in vorteilhafter Weise eine zeitlich veränderbare Triggermaske realisiert.

Weiterhin kann die Triggermaske 18 eine Oberfläche mit einer topographischen Oberflächenstruktur aufweisen, an der der Abtaststrahl 22 beugend reflektiert wird.

Für beide Ausgestaltungen der Strahlführungsmaske, die den Abtaststrahl in Richtung zurück auf die Lichtquelle 26 reflektiert, ist im Strahlengang des Abtaststrahls 22 in Strahlrichtung vor dem Scanspiegel 12 ein Strahlauskoppler 46 vorgesehen. Dieser leitet den reflektierten Abtaststrahl 22 auf den Detektor 30'. Dort wird das Detektionssignal als Steuersignal für die Steuerungsmittel 36 erzeugt.

Weiterhin kann die Triggermaske 18 eine Oberfläche mit unterschiedlichen Transmissionseigenschaften aufweisen. Somit wird der Abtaststrahl 22 unterschiedlich stark durchgelassen. Der durchgelassene Anteil des Abtaststrahls 22 wird mit einer Optik 48 auf die Oberfläche des Detektors 30'' fokussiert. Dort wird dann das Steuersignal für die Steuerungsmittel 36 erzeugt, das über die Leitung 42 übertragen wird.

Auch in diesem Fall kann das Material der Triggermaske 18 in verschiedener Weise ausgebildet sein. Die unterschiedlichen Transmissionseigenschaften können durch unterschiedliche Einfärbungen des an sich lichtdurchlässigen Materials erzeugt werden. Die Triggermaske 18 kann aber auch in diesem Fall als räumlicher Strahlmodulator (spatial light modulator - SLM) ausgebildet sein. Dadurch wird in vorteilhafter Weise eine zeitlich veränderbare transmittierende Triggermaske realisiert.

Die Steuerungsmittel 36 zum Erzeugen eines zeitlichen Triggersignals weisen Computermittel auf, die mit den Detektoren 30' und/oder 30'' verbunden sind. Diese vergleichen das von den Detektoren aufgenommen Signal mit Sollwerten, so dass das Steuersignal für die Intensitätssteuerung erzeugt wird.

Die Steuerungsmittel 36 können ebenfalls zum Erzeugen eines Intensitätssteuersignals eingesetzt werden. Dazu weisen die Steuerungsmittel 36 Speichermittel auf, in denen zu den vorgegebenen Positionen entlang der Spuren 44 Intensitätswerte abgelegt sind, die jeweils ausgelesen und zum Steuern der Intensität der Lichtquelle 8 eingesetzt werden.

Ein weiteres Merkmal der zuvor beschriebenen Ausgestaltungen des Lithographen besteht darin, dass der Abstand zwischen dem Speichermedium 4 und dem Objektiv 16 in Fig. 1 variabel einstellbar ist. Dieses ist mit einem mit "Z" bezeichneten Doppelpfeil gekennzeichnet. Für ein Verstellen des Abstandes in z-Richtung sind in den Figuren nicht dargestellte Mittel vorgesehen. Dieses können jegliche linearen Verstellmittel sein, die motorisch oder per Hand angetrieben sein können. Durch ein Verstellen des Abstandes kann die Lage des Fokus im Speichermedium 4 in verschiedenen Tiefen angeordnet werden, ebenso ist eine Justierung des Fokus bei unterschiedlich dicken Speichermedien 4 möglich. Schließlich können mindestens zwei digitale Hologramme in verschiedenen Ebenen innerhalb des Speichermediums 4 eingeschrieben werden, um sogenannte Mehrschichthologramme zu erzeugen.

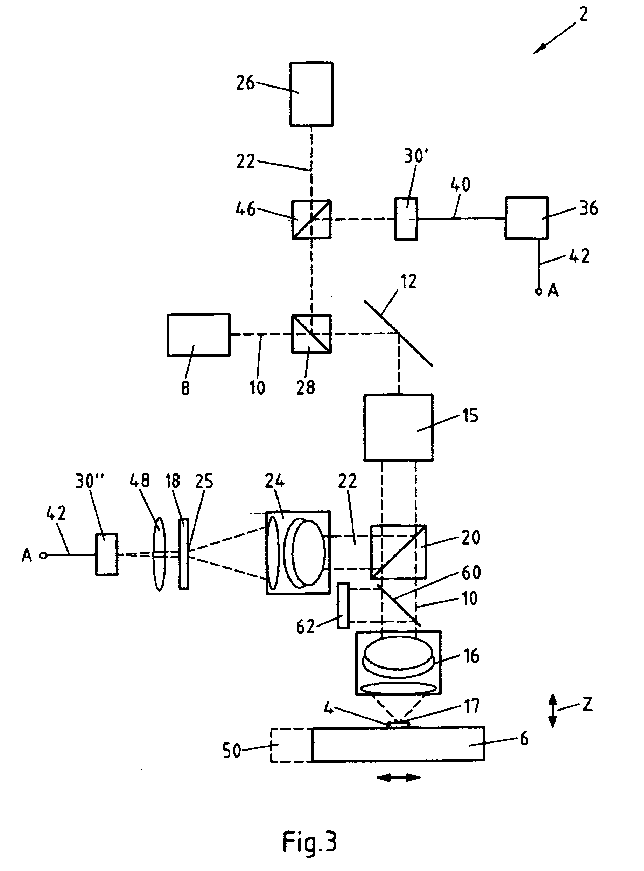

In Fig. 3 ist ein erfindungsgemäßes Mikroskop dargestellt, das in seinem Aufbau dem in Fig. 1 dargestellten Lithographen entspricht. Daher bezeichnen gleiche Bezugszeichen gleiche Bauteile wie im Zusammenhang mit Fig. 1 beschrieben worden sind, auch wenn im einzelne andere Bezeichnungen verwendet werden, die den Unterschied zwischen Schreiben und Beobachten kennzeichnen.

Zusätzlich zum in Fig. 1 dargestellten Aufbau ist im Strahlengang des von der Oberfläche reflektierten Lichtes hinter, also oberhalb des Objektivs 16 eine Umlenkebene 60 angeordnet. Diese kann durch einen halbdurchlässigen Spiegel oder einen Strahlteiler verwirklicht sein und beeinflusst nicht oder nur unwesentlich den Beobachtungsstrahl.

Die Umlenkebene 60 lenkt den reflektierten Strahl seitlich, in Fig. 3 nach links ab, so dass dieser auf einen Photosensor 62 trifft, der die Intensität des reflektierten Lichtes misst.

Durch das Verändern des Beobachtungsstrahls 10 relativ zum zu mikroskopierenden Objekt 4 wird dann die Oberfläche abgetastet und punktweise die Reflektivität gemessen. Somit kann eine Abbildung der abgetasteten Oberfläche zusammengesetzt werden.

Wird nun der von der Lichtquelle 8 emittierte Lichtstrahl, der bei dem Mikroskop als Beobachtungsstrahl bezeichnet werden kann, mit im wesentlichen gleich starker Intensität erzeugt, so ist die gemessene Intensität des reflektierten Strahls ein Maß für die Reflektivität der abgetasteten Oberfläche.

## Patentansprüche

1. Verfahren zum Herstellen digitaler Hologramme in einem Speichermedium,
- bei dem ein Schreibstrahl auf das Speichermedium fokussiert und eindimensional relativ zum Speichermedium bewegt wird,
- bei dem ein Abtaststrahl auf eine eine Mehrzahl von Triggerlinien aufweisende Triggermaske fokussiert und eindimensional quer zu den Triggerlinien bewegt wird, wobei die Bewegung des Abtaststrahls mit der Bewegung des Schreibstrahls gekoppelt wird,
- bei dem während des Abtastens der Triggerlinien in Abhängigkeit von der Anordnung der Triggerlinien ein zeitliches Triggersignal erzeugt wird,
- bei dem mit Hilfe des zeitlichen Triggersignals die Intensität des Schreibstrahls auf dem Speichermedium geregelt wird, und
- bei dem das Hologramm zeilenweise durch punktweises Einbringen von Strahlungsenergie geschrieben wird, wobei das Speichermedium quer zur Scanrichtung der Zeilen um einen vorgegebenen Abstand für ein Schreiben benachbarter Linien des Hologramms verstellt wird.

2. Verfahren nach Anspruch 1,
bei dem die Triggerlinien parallel, vorzugsweise in einem orthogonalen Raster, angeordnet werden.

3. Verfahren nach Anspruch 1 oder 2,
bei dem mit Hilfe der zeitlichen Triggerinformation und einer zusätzlichen Intensitätsinformation das digitale Hologramm punktweise in Zeilen nacheinander geschrieben wird.

4. Verfahren nach Anspruch 3,
bei dem die Intensitätsinformation unabhängig von der Triggermaske erzeugt wird.

5. Verfahren nach einem der Ansprüche 1 bis 4,
bei dem das Speichermedium während des Einschreibens einer Zeile gegenüber dem Schreibstrahl unverändert gehalten wird und während eines Zeilenwechsels des Schreibstrahls um den Abstand einer Zeile bewegt wird.

6. Verfahren nach einem der Ansprüche 1 bis 4,
bei dem das Speichermedium während des Schreibens kontinuierlich verschoben wird.

7. Verfahren nach einem der Ansprüche 1 bis 6,
bei dem der Abtaststrahl in einem vorgegebenen Bewegungsverhältnis zum Schreibstrahl bewegt wird.

8. verfahren nach einem der Ansprüche 1 bis 7,
bei dem der Abtaststrahl auf eine Größe fokussiert wird, die maximal der Triggerlinienabmessung der Triggermaske entspricht.

9. Verfahren nach einem der Ansprüche 1 bis 8,
bei dem die Triggerlinien der Triggermaske eine von der umgebenden Oberfläche seitlich neben den Triggerlinien unterschiedliche Reflektivität aufweisen und bei dem aus der Intensität des von der Oberfläche der Triggermaske reflektierten Strahls das Triggersignal abgeleitet wird.

10. Verfahren nach einem der Ansprüche 1 bis 8,
bei dem die Triggerlinien der Triggermaske eine von der umgebenden Oberfläche seitlich neben den Triggerlinien unterschiedliche Transmissionseigenschaft aufweisen und bei dem aus der Intensität des durch die Triggermaske transmittierten Strahls das Triggersignal abgeleitet wird.

11. Verfahren nach einem der Ansprüche 1 bis 8,
bei dem die Triggerlinien der Triggermaske eine Oberflächenstruktur, beispielsweise in Form von Rillen, aufweisen und bei dem aus der Intensität des an der Oberfläche der Triggermaske reflektierend gebeugten Strahls das Triggersignal abgeleitet wird.

12. Verfahren nach einem der Ansprüche 1 bis 8,
bei dem die Triggermaske aktive Pixel aufweist und bei dem das zeitliche Triggersignal direkt durch die aktiven Pixel erzeugt wird.

13. Verfahren nach Anspruch 12,
bei dem als aktive Triggermaske ein räumlicher Strahlmodulator verwendet wird.

14. Verfahren nach einem der Ansprüche 1 bis 13,
bei dem der Abstand zwischen dem Objektiv und dem Speichermedium für ein Schreiben in verschiedenen Tiefen innerhalb des Speichermediums eingestellt wird.

15. Lithograph zum Herstellen digitaler Hologramme in einem Speichermedium (4), insbesondere zum Durchführen eines Verfahrens nach einem der Ansprüche 1 bis 13,
- mit einer Lichtquelle (8) zum Erzeugen eines Schreibstrahls (10),
- mit Antriebsmitteln (12) zum eindimensionalen Bewegen des Schreibstrahls (10) relativ zum Speichermedium (4) und
- mit einem ersten Objektiv (16) zum Fokussieren des Schreibstrahls (10) auf das zu beschreibende Speichermedium (4),
**dadurch gekennzeichnet,**
- **dass** eine eine Mehrzahl von Triggerlinien aufweisenden Triggermaske (18) vorgesehen ist,
- **dass** Mittel (20) zum Erzeugen eines Abtaststrahls (22) vorgesehen sind,
- **dass** ein zweites Objektiv (24) zum Fokussieren des Abtaststrahls (22) auf die Triggermaske(18) vorgesehen ist,
- **dass** die Antriebsmittel (12) den Abtaststrahl (22) relativ zur Oberfläche der Triggermaske(18) bewegen, wobei die Bewegung des Abtaststrahls (22) mit der Bewegung des Schreibstrahls (10) gekoppelt ist,
- **dass** ein Detektor (30',30'') zum Aufnehmen des durch die optischen Eigenschaften der Triggerlinien (44) intensitätsvariierten Abtaststrahls vorgesehen ist,
- **dass** Steuermittel (36) zum Erzeugen eines Triggersignals in Abhängigkeit vom Signal des Detektors (30',30'') vorgesehen sind.

16. Lithograph nach Anspruch 15,
**dadurch gekennzeichnet,**
**dass** die Steuermittel (36) auch für ein Erzeugen eines Signals zum Steuern der Intensität des Schreibstrahls (10) vorgesehen sind.

17. Lithograph nach Anspruch 15 oder 16,
**dadurch gekennzeichnet,**
- **dass** die Antriebsmittel (12) als x/y-Scanspiegelanordnung zum Bewegen des Schreibstrahls (10) ausgebildet sind und
- **dass** die Mittel zum Erzeugen des Abtaststrahls (22) Mittel (20) zum Auskoppeln eines Teils des Schreibstrahls (10) als Abtaststrahl (22) im Strahlengang des Schreibstrahls (10) hinter den Antriebsmitteln (12) aufweisen.

18. Lithograph nach Anspruch 17,
**dadurch gekennzeichnet,**
**dass** die Mittel zum Erzeugen des Abtaststrahls (22)
- eine zweite Lichtquelle (26) zum Erzeugen eines Abtaststrahls (22) mit einer vom Schreibstrahl (10) abweichenden Wellenlänge oder Polarisation und
- Einkoppelmittel (28) zum Einkoppeln des Abtaststrahls (22) in den Strahlengang des Schreib strahls (10) vor den Antriebsmitteln (12) aufweisen und
- **dass** die Mittel (20) zum Auskoppeln den Abtaststrahl (22) auskoppeln.

19. Lithograph nach einem der Ansprüche 15 bis 18,
**dadurch gekennzeichnet,**
**dass** Mittel (50) zum Bewegen des Speichermediums (4) relativ zum Schreibstrahl (10) vorgesehen sind.

20. Lithograph nach einem der Ansprüche 15 bis 19,
**dadurch gekennzeichnet,**
**dass** ein längenbezogenes Übersetzungsverhältnis zwischen der Bewegung des Abtaststrahls (22) auf der Triggermaske(18) und des Schreibstrahls (10) auf dem Speichermedium (4) vorgegeben ist.

21. Lithograph nach Anspruch 20,
**dadurch gekennzeichnet,**
**dass** die Brennweite des zweiten Objektivs (24) um einen vorgegebenen Faktor größer als die Brennweite des ersten Objektivs (16) ist

22. Lithograph nach einem der Ansprüche 15 bis 21,
**dadurch gekennzeichnet,**
**dass** die Triggermaske(18) eine Mehrzahl von Triggerlinien (44) aufweist.

23. Lithograph nach Anspruch 22,
**dadurch gekennzeichnet,**
**dass** die Triggerlinien (44) in einem Raster, insbesondere orthogonalem Raster, angeordnet sind.

24. Lithograph nach einem der Ansprüche 15 bis 23,
**dadurch gekennzeichnet,**
**dass** die Triggermaske(18) eine Oberfläche mit unterschiedlichen Reflexionseigenschaften aufweist.

25. Lithograph nach Anspruch 24,
**dadurch gekennzeichnet,**
**dass** die Triggermaske(18) als räumlicher Strahlmodulator ausgebildet ist.

26. Lithograph nach einem der Ansprüche 15 bis 23,
**dadurch gekennzeichnet,**
**dass** die Triggermaske(18) eine Oberfläche mit einer topographischen Oberflächenstruktur aufweist, an der der Abtaststrahl reflektiert wird.

27. Lithograph nach einem der Ansprüche 15 bis 23,
**dadurch gekennzeichnet,**
**dass** die Triggermaske(18) eine Oberfläche mit unterschiedlichen Transmissionseigenschaften aufweist.

28. Lithograph nach Anspruch 27,
**dadurch gekennzeichnet,**
**dass** die Triggermaske(18) als räumlicher Strahlmodulator ausgebildet ist.

29. Lithograph nach Anspruch 27 oder 28,
**dadurch gekennzeichnet,**
**dass** eine Fokussierungsoptik (48) zum Fokussieren der transmittierten Strahlung auf den Detektor (30'') vorgesehen ist.

30. Lithograph nach einem der Ansprüche 15 bis 29,
**dadurch gekennzeichnet,**
**dass** Mittel zum Verstellen des Abstandes zwischen dem Speichermedium (4) und dem Objektiv (16) vorgesehen sind.

31. Mikroskop zum Abtasten eines Objektes (4),
- mit einer Lichtquelle (8) zum Erzeugen eines Abtaststrahls (10),
- mit Antriebsmitteln (12) zum eindimensionalen Bewegen des Abtaststrahls (10) relativ zum Objekt (4) und
- mit einem ersten Objektiv (16) zum Fokussieren des Abtaststrahls (10) auf das Objekt (4),
**dadurch gekennzeichnet,**
- **dass** eine eine Mehrzahl von Triggerlinien aufweisenden Triggermaske (18) vorgesehen ist,
- **dass** Mittel (20) zum Erzeugen eines Abtaststrahls (22) vorgesehen sind,
- **dass** ein zweites Objektiv (24) zum Fokussieren des Abtaststrahls (22) auf die Triggermaske (18) vorgesehen ist,
- **dass** die Antriebsmittel (12) den Abtaststrahl (22) relativ zur Oberfläche der Triggermaske(18) bewegen, wobei die Bewegung des Abtaststrahls (22) mit der Bewegung des Abtaststrahls (10) gekoppelt ist,
- **dass** ein Detektor (30',30'') zum Aufnehmen des durch die optischen Eigenschaften der Triggerlinien (44) intensitätsvariierten Abtaststrahls vorgesehen ist und
- **dass** Steuermittel (36) zum Erzeugen eines Triggersignals in Abhängigkeit vom Signal des Detektors (30',30'') vorgesehen sind.

32. Mikroskop nach Anspruch 31 mit einem oder mehreren Merkmalen eines der Ansprüche 15 bis 30.

## Claims

1. A process for producing digital holograms in a storage medium,
- in which a writing beam is focused onto the storage medium and is moved in one dimension relative to the storage medium,
- in which a scanning beam is focused onto a trigger mask having a plurality of trigger lines and is moved in one dimension transversely with respect to the trigger lines, with the movement of the scanning beam being coupled with the movement of the writing beam,
- in which during scanning of the trigger lines a time-dependent trigger signal is generated as a function of the arrangement of the trigger lines,
- in which the intensity of the writing beam on the storage medium is regulated with the aid of the time-dependent trigger signal, and
- in which the hologram is written line by line by introducing beam energy point by point, with the storage medium being displaced transversely with respect to the scanning direction of the lines by a predetermined distance in order to write adjacent lines of the hologram.

2. A process according to Claim 1, in which the trigger lines are arranged parallel, preferably in an orthogonal pattern.

3. A process according to Claim 1 or 2, in which the digital hologram is written point by point in lines one after the other with the aid of the time-dependent trigger information and an additional item of information relating to intensity.

4. A process according to Claim 3, in which the item of information relating to intensity is generated independently of the trigger mask.

5. A process according to one of Claims 1 to 4, in which the storage medium is kept unchanged with respect to the writing beam while a line is recorded and is moved by the distance of one line when the writing beam changes line.

6. A process according to one of Claims 1 to 4, in which the storage medium is displaced continuously during writing.

7. A process according to one of Claims 1 to 6, in which the scanning beam is moved in a predetermined relationship of movement with respect to the writing beam.

8. A process according to one of Claims 1 to 7, in which the scanning beam is focused to a size corresponding at most to the dimension of a trigger line of the trigger mask.

9. A process according to one of Claims 1 to 8, in which the trigger lines of the trigger mask have a different reflectance from the surrounding surface laterally next to the trigger lines, and in which the trigger signal is derived from the intensity of the beam reflected by the surface of the trigger mask.

10. A process according to one of Claims 1 to 8, in which the trigger lines of the trigger mask have a different transmission property from the surrounding surface laterally next to the trigger lines, and in which the trigger signal is derived from the intensity of the beam transmitted by the trigger mask.

11. A process according to one of Claims 1 to 8, in which the trigger lines of the trigger mask have a surface texture, for example in the form of grooves, and in which the trigger signal is derived from the intensity of the beam diffracted such that it is reflected at the surface of the trigger mask.

12. A process according to one of Claims 1 to 8, in which the trigger mask has active pixels, and in which the time-dependent trigger signal is generated directly by the active pixels.

13. A process according to Claim 12, in which a spatial light modulator is used as the active trigger mask.

14. A process according to one of Claims 1 to 13, in which the distance between the lens and the storage medium is adjusted for writing at different depths within the storage medium.

15. A lithograph for producing digital holograms in a storage medium (4), in particular for carrying out a process according to one of Claims 1 to 13,
- having a light source (8) for generating a writing beam (10),
- having drive means (12) for moving the writing beam (10) in one dimension relative to the storage medium (4), and
- having a first lens (16) for focusing the writing beam (10) on the storage medium (4) in which the recording is to be made,
**characterised**
- **in that** a trigger mask (18) having a plurality of trigger lines is provided,
- **in that** means (20) are provided for generating a scanning beam (22),
- **in that** a second lens (24) is provided for focusing the scanning beam (22) onto the trigger mask (18),
- **in that** the drive means (12) move the scanning beam (22) relative to the surface of the trigger mask (18), with the movement of the scanning beam (22) being coupled with the movement of the writing beam (10),
- **in that** a detector (30', 30") is provided for receiving the scanning beam, whereof the intensity varies as a result of the optical properties of the trigger lines (44),
- **in that** control means (36) are provided for generating a trigger signal as a function of the signal from the detector (30', 30").

16. A lithograph according to Claim 15, **characterised in that** the control means (36) are also provided for generating a signal for controlling the intensity of the writing beam (10).

17. A lithograph according to Claim 15 or 16, **characterised**
- **in that** the drive means (12) are constructed in an x/y scanning mirror arrangement for moving the writing beam (10), and
- **in that** the means for generating the scanning beam (22) have means (20) for splitting off part of the writing beam (10) as a scanning beam (22) in the path of the writing beam (10) downstream of the drive means (12).

18. A lithograph according to Claim 17, **characterised in that** the means for generating the scanning beam (22) have
- a second light source (26) for generating a scanning beam (22) with a wavelength or polarisation different from the writing beam (10), and
- coupling means (28) for coupling the scanning beam (22) to the path of the writing beam (10) upstream of the drive means (12), and
- **in that** the means (20) for splitting off split off the scanning beam (22).

19. A lithograph according to one of Claims 15 to 18, **characterised in that** means (50) are provided for moving the storage medium (4) relative to the writing beam (10).

20. A lithograph according to one of Claims 15 to 19, **characterised in that** a lengthwise transmission ratio between the movement of the scanning beam (22) on the trigger mask (18) and that of the writing beam (10) on the storage medium (4) is predetermined.

21. A lithograph according to Claim 20, **characterised in that** the focal length of the second lens (24) is larger than the focal length of the first lens (16) by a predetermined factor.

22. A lithograph according to one of Claims 15 to 21, **characterised in that** the trigger mask (18) has a plurality of trigger lines (44).

23. A lithograph according to Claim 22, **characterised in that** the trigger lines (44) are arranged in a pattern, in particular an orthogonal pattern.

24. A lithograph according to one of Claims 15 to 23, **characterised in that** the trigger mask (18) has a surface with different reflection properties.

25. A lithograph according to Claim 24, **characterised in that** the trigger mask (18) is constructed as a spatial light modulator.

26. A lithograph according to one of Claims 15 to 23, **characterised in that** the trigger mask (18) has a surface with a topographical surface texture at which the scanning beam is reflected.

27. A lithograph according to one of Claims 15 to 23, **characterised in that** the trigger mask (18) has a surface with different transmission properties.

28. A lithograph according to Claim 27, **characterised in that** the trigger mask (18) is constructed as a spatial light modulator.

29. A lithograph according to Claim 27 or 28, **characterised in that** a focusing optical system (48) is provided for focusing the transmitting beam onto the detector (30").

30. A lithograph according to one of Claims 15 to 29, **characterised in that** means are provided for altering the distance between the storage medium (4) and the lens (16).

31. A microscope for scanning an object (4),
- having a light source (8) for generating a scanning beam (10),
- having drive means (12) for moving the scanning beam (10) in one dimension relative to the object (4), and
- having a first lens (16) for focusing the scanning beam (10) onto the object (4),
**characterised**
- **in that** a trigger mask (18) having a plurality of trigger lines is provided,
- **in that** means (20) are provided for generating a scanning beam (22),
- **in that** a second lens (24) is provided for focusing the scanning beam (22) on the trigger mask (18),
- **in that** the drive means (12) move the scanning beam (22) relative to the surface of the trigger mask (18), with the movement of the scanning beam (22) being coupled with the movement of the scanning beam (10),
- **in that** a detector (30', 30") is provided for receiving the scanning beam, whereof the intensity varies as a result of the optical properties of the trigger lines (44), and
- **in that** control means (36) are provided for generating a trigger signal as a function of the signal from the detector (30', 30").

32. A microscope according to Claim 31, having one or more of the features of one of Claims 15 to 30.

## Revendications

1. Procédé pour fabriquer des hologrammes numériques sur un support de mémoire,
- selon lequel un faisceau d'écriture est focalisé sur le support de mémoire et est déplacé de façon unidimensionnelle par rapport au support de mémoire,
- selon lequel on focalise un faisceau d'exploration par balayage sur un masque de déclenchement qui comporte une multiplicité de lignes de déclenchement, et on le déplace d'une manière unidimensionnelle transversalement par rapport aux lignes de déclenchement, le déplacement du faisceau d'exploration par balayage étant couplé au déplacement du faisceau d'écriture,
- selon lequel pendant l'exploration par balayage des lignes de déclenchement, un signal temporel de déclenchement est produit en fonction de la disposition des lignes de déclenchement,
- selon lequel à l'aide du signal temporel de déclenchement on règle l'intensité du faisceau d'écriture sur le support de mémoire, et
- selon lequel on écrit l'holôgramme ligne par ligne au moyen d'une introduction ponctuelle d'une énergie de rayonnement, le support de mémoire étant déplacé transversalement par rapport à la direction de balayage des lignes, d'une distance prédéterminée pour une écriture de lignes voisines de l'hologramme.

2. Procédé selon la revendication 1, selon lequel les lignes de déclenchement sont disposées parallèlement, de préférence sous la forme d'un réseau orthogonal.

3. Procédé selon la revendication 1 ou 2, selon lequel on écrit successivement et de façon ponctuelle l'hologramme numérique selon des lignes à l'aide d'une information temporelle de déclenchement et d'une information supplémentaire d'intensité.

4. Procédé selon la revendication 3, selon lequel l'information d'intensité est produite indépendamment du masque de déclenchement.

5. Procédé selon l'une des revendications 1 à 4, selon lequel pendant l'écriture d'une ligne on maintient le support de mémoire inchangé par rapport au faisceau d'écriture et on le déplace pendant un changement de ligne du faisceau d'écriture, et ce de la distance d'une ligne.

6. Procédé selon l'une des revendications 1 à 4, selon lequel le support de mémoire est déplacé continûment pendant l'écriture.

7. Procédé selon l'une des revendications 1 à 6, selon lequel on déplace le faisceau d'exploration par balayage selon un rapport de déplacement prédéterminé par rapport au faisceau d'écriture.

8. Procédé selon l'une des revendications 1 à 7, selon lequel on focalise le faisceau d'exploration par balayage sur une taille, qui correspond au maximum à la dimension des lignes de déclenchement du masque de déclenchement.

9. Procédé selon l'une des revendications 1 à 8, selon lequel, dans les lignes de déclenchement du masque de déclenchement, les surfaces situées latéralement à côté des lignes de déclenchement, possèdent une réflectivité différente et selon lequel le signal de déclenchement est dérivé de l'intensité du faisceau réfléchi par la surface du masque de déclenchement.

10. Procédé selon l'une des revendications 1 à 8, selon lequel les lignes de déclenchement du masque de déclenchement possèdent une caractéristique de transmission différente de la surface, latéralement à côté des lignes de déclenchement et selon lequel le signal de déclenchement est dérivé de l'intensité du faisceau transmis par le masque de déclenchement.

11. Procédé selon l'une des revendications 1 à 8, selon lequel les lignes de déclenchement du masque de déclenchement possèdent une structure de surface, par exemple sous la forme de rainures, et selon lequel le signal de déclenchement est dérivé de l'intensité du faisceau diffracté par réflexion sur la surface du masque de déclenchement.

12. Procédé selon l'une des revendications 1 à 8, selon lequel le masque de déclenchement possède des pixels actifs et selon lequel le signal temporel de déclenchement est produit directement par les pixels actifs.

13. Procédé selon la revendication 12, selon lequel on utilise comme masque de déclenchement actif un modulateur spatial de faisceau.

14. Procédé selon l'une des revendications 1 à 13, selon lequel on règle la distance entre l'objectif et le support de mémoire pour une écriture à différentes profondeurs à l'intérieur du support de mémoire.

15. Lithographe pour fabriquer des hologrammes nuémriques sur un support de mémoire (4), notamment pour la mise en oeuvre d'un procédé selon les revendications 1 à 13, comportant
- une source de lumière (8) pour produire un faisceau d'écriture (10),
- des moyens d'entraînement (12) pour réaliser un déplacement unidimensionnel du faisceau d'écriture (10) par rapport au support de mémoire (4); et
- un premier objectif (16) pour focaliser le faisceau d'écriture (10) sur le support de mémoire (4) sur lequel l'écriture doit être réalisée,
**caractérisé en ce**
- **qu'**il est prévu un masque de déclenchement (18) possédant une multiplicité de lignes de déclenchement,
- **que** des moyens (20) sont prévus pour produire un faisceau d'exploration par balayage (22),
- **qu'**un second objectif (24) est prévu pour focaliser le faisceau d'exploration par balayage sur le masque de déclenchement (18),
- **que** les moyens d'entraînement (12) déplacent le faisceau d'exploration par balayage (22) par rapport à la surface du masque de déclenchement (18), le déplacement du faisceau d'exploration par balayage (22) étant couplé au déplacement du faisceau d'écriture (10),
- **qu'**il est prévu un détecteur (30', 30") pour l'enregistrement du faisceau d'exploration par balayage dont l'intensité est modifiée par les caractéristiques optiques des lignes de déclenchement (44),
- **que** des moyens de commande (36) sont prévus pour la production d'un signal de déclenchement en fonction du signal du détecteur (30', 30").

16. Lithographe selon la revendication 15, **caractérisé en ce que** les moyens de commande (36) sont également prévus pour la production d'un signal pour la commande de l'intensité du faisceau d'écriture (10).

17. Lithographe selon la revendication 15 ou 16, **caractérisé en ce**
- **que** les moyens d'entraînement (12) sont agencés sous la forme d'un dispositif à miroir de balayage x/y pour déplacer le faisceau d'écriture (10), et
- **que** les moyens de production du faisceau d'exploration par balayage (22) comportent les moyens (20) pour découpler une partie du faisceau d'écriture (10) en tant que faisceau d'exploration par balayage (22) dans le trajet du faisceau d'écriture (10) en arrière des moyens d'entraînement (12).

18. Lithographe selon la revendication 17, **caractérisé en ce que** les moyens de production du faisceau d'exploration par balayage (22) comprennent :
- une seconde source de lumière (26) pour produire un faisceau d'exploration par balayage (22) ayant une longueur d'onde ou une polarisation, qui diffère de celle du faisceau d'écriture (10), et
- des moyens de couplage (28) pour injecter le faisceau d'exploration par balayage (22) dans le trajet du faisceau d'écriture (10) en amont des moyens d'entraînement (12), et
- que les moyens de découplage (20) découplent le faisceau d'exploration par balayage (22).

19. Lithographe selon l'une des revendications 15 à 18, **caractérisé en ce que** des moyens (50) sont prévus pour déplacer le support de mémoire (4) par rapport au faisceau d'écriture (10).

20. Lithographe selon l'une des revendications 15 à 19, **caractérisé en ce qu'**un rapport de conversion, rapporté à la longueur, entre le mouvement du faisceau d'exploration par balayage (22) sur le masque de déclenchement (18) et le déplacement du faisceau d'écriture (10) sur le support de mémoire (4) est prédéterminé.

21. Lithographe selon la revendication 20, **caractérisé en ce que** la distance focale du second objectif (24) est supérieure, d'un facteur prédéterminé, à la distance focale du premier objectif (16).

22. Lithographe selon l'une des revendications 15 à 21, **caractérisé en ce que** le masque de déclenchement (18) possède une multiplicité de lignes de déclenchement (44).

23. Lithographe selon la revendication 22, **caractérisé en ce que** les lignes de déclenchement (44) sont disposées selon un réseau, notamment un réseau orthogonal.

24. Lithographe selon l'une des revendications 15 à 23, **caractérisé en ce que** le masque de déclenchement (18) comporte une surface possédant des caractéristiques de réflexion différentes.

25. Lithographe selon la revendication 24, **caractérisé en ce que** le masque de déclenchement (18) est agencé sous la forme d'un modulateur de faisceau spatial.

26. Lithographe selon l'une des revendications 15 à 23, **caractérisé en ce que** le masque de déclenchement (18) possède une surface possédant une structure de surface topographique, sur laquelle le faisceau d'exploration par balayage est réfléchi.

27. Lithographe selon l'une des revendications 15 à 23, **caractérisé en ce que** le masque de déclenchement (18) possède une surface ayant des caractéristiques de transmission différentes.

28. Lithographe selon la revendication 27, **caractérisé en ce que** le masque de déclenchement (18) est agencé sous la forme d'un modulateur de faisceau spatial.

29. Lithographe selon la revendication 27 ou 28, **caractérisé en ce qu'**un système optique de focalisation (48) est prévu pour focaliser le rayonnement transmis sur le détecteur (30").

30. Lithographe selon l'une des revendications 15 à 29, **caractérisé en ce que** des moyens sont prévus pour régler la distance entre le support de mémoire (4) et l'objectif (16).

31. Microscope pour l'exploration par balayage d'un objet (4), comportant
- une source de lumière (8) pour produire un faisceau d'exploration par balayage (10),
- des moyens d'entraînement (12) pour réaliser le déplacement unidimensionnel du faisceau d'exploration par balayage (10) par rapport à l'objet (4), et
- un premier objectif (7) pour focaliser le faisceau d'exploration par balayage (10) sur l'objet (4),
**caractérisé en ce**
- **qu'**il est prévu un masque de déclenchement (18) possédant une multiplicité de lignes de déclenchement,
- **que** des moyens (20) sont prévus pour produire un faisceau d'exploration par balayage (22),
- **qu'**un deuxième objectif (34) est prévu pour focaliser le faisceau d'exploration par balayage (22) sur le masque de déclenchement (18),
- **que** des moyens d'entraînement (12) déplacent le faisceau d'exploration par balayage (22) par rapport à la surface du masque de déclenchement (18), le déplacement du faisceau d'exploration par balayage (22) étant couplé au déplacement du faisceau d'exploration par balayage (10),
- **qu'**un détecteur (30', 30") est prévu pour l'enregistrement du faisceau d'exploration par balayage dont l'intensité varie sous l'effet des caractéristiques optiques des lignes de déclenchement (44), et
- **que** des moyens de commande (36) sont prévus pour la production d'un signal de déclenchement en fonction du signal du détecteur (30', 30").

32. Microscope selon la revendication 31, comportant une ou plusieurs caractéristiques des revendications 15 à 30.
